Europäisches Patentamt

European Patent Office

Office européen des brevets

(19)

(11) Publication number: **0 086 334**
**B1**

## EUROPEAN PATENT SPECIFICATION

(12)

(45) Date of publication of patent specification: **02.07.86**

(21) Application number: **83100238.1**

(22) Date of filing: **13.01.83**

(51) Int. Cl.⁴: **H 03 K 3/017,** H 03 K 5/04, H 03 K 5/156

(54) Pulse duty conversion circuit.

(30) Priority: **28.01.82 JP 12317/82**

(43) Date of publication of application:
**24.08.83 Bulletin 83/34**

(45) Publication of the grant of the patent:
**02.07.86 Bulletin 86/27**

(84) Designated Contracting States:
**DE FR GB**

(56) References cited:
**DE-A-2 022 548**
**GB-A- 916 630**
**GB-A-1 107 629**
**US-A-3 590 283**
**US-A-3 711 729**
**US-A-3 712 993**
**US-A-3 770 987**
**US-A-4 140 928**

**Patent Abstracts of Japan, vol. 3, no. 22, 24 February 1979, page 116E93 & JP-A-54-958 "Halbleiter-Schaltungstechnik" by U. Tietze and Ch. Schenk, 6th edition, Springer Verlag Berlin Heidelberg New York Tokyo 1983, pp. 59-63 "Operational Amplifier Characteristics and Applications" by R. Irvine Preutke-Holl, Inc. Englewood Cliff. 1981, pp. 22-23**

(73) Proprietor: **Kabushiki Kaisha Toshiba**
**72, Horikawa-cho Saiwai-ku**
**Kawasaki-shi Kanagawa-ken 210 (JP)**

(72) Inventor: **Tezuka, Hideharu**
**1291 Tsukui**
**Yokosuka-shi Kanagawa-ken (JP)**
Inventor: **Agawa, Yasushi**
**33-3, Torigaoka**
**Totsuka-ku Yokohama-shi (JP)**

(74) Representative: **Lehn, Werner, Dipl.-Ing. et al**
**Hoffmann, Eitle & Partner Patentanwälte**
**Arabellastrasse 4 (Sternhaus)**
**D-8000 München 81 (DE)**

## Description

This invention relates to a pulse regeneration circuit comprising: a first current source means for supplying a first electric current; a second current source means of supplying a second electric current; a capacitor means connected between said first and second current source means; a first switching means connected between said first current source means and a reference potential and controlled by an input pulse signal; a second switching means connected in parallel to said first switching means; a third switching means connected at one end to a power source potential through a load means and at the other end to said reference potential and controlled by the potential of said capacitor means; and the potential at said one end of said third switching means forming an output and being applied to said second switching means through an impedance means to control said second switching means.

Such a circuit is known from US—A—3 590 283. This circuit provides a feed back loop to maintain the astable state in the event of dropping of the input potential thus maintaining the output pulse duty approximately constant. However, owing to the parallel connection of the first and second switching means, which are first and second transistors (collector emitter paths), the impedance between capacitor and ground alters slightly when the input pulse drops and switches off the first transistor, thus slightly changing the output pulse duty in spite of continued conduction by the second transistor.

This is a disadvantage when extermely accurate pulse duty is required at the output.

Known ways of achieving extremely accurate pulse duty involve use of many circuit elements and complex circuitry. Such a circuit is inevitably large and complex.

Accordingly, it is an object of the present invention to provide a pulse regeneration circuit which not only is comprised of a relatively small number of elements and has a relatively simple structure, but also is able to provide an output pulse signal whose pulse duty remains substantially constant in the face of changes in the duty of the input signal.

According to the invention, the circuit defined in the first paragraph of this specification is characterised in that said first and second current source means are first and second constant current source means forming a current mirror circuit, whereby the pulse duty of said output is stable and substantially independent of the pulse duty of said input pulse signal.

This invention can be more fully understood from the following detailed description when taken in conjunction with the accompanying drawings, in which:

Fig. 1 is a circuit diagram of a pulse regeneration circuit according to the present invention;

Figs. 2A through 2D are timing charts of the signals supplied to various elements of the circuit shown in Fig. 1;

Fig. 3 is a block diagram of a doubler circuit, a combination of the pulse regeneration circuit of the present invention and a monostable multivibrator of a dual trigger monostable type; and

Fig. 4A through 4C are timing charts of the signals supplied to the various elements of the doubler circuit shown in Fig. 3.

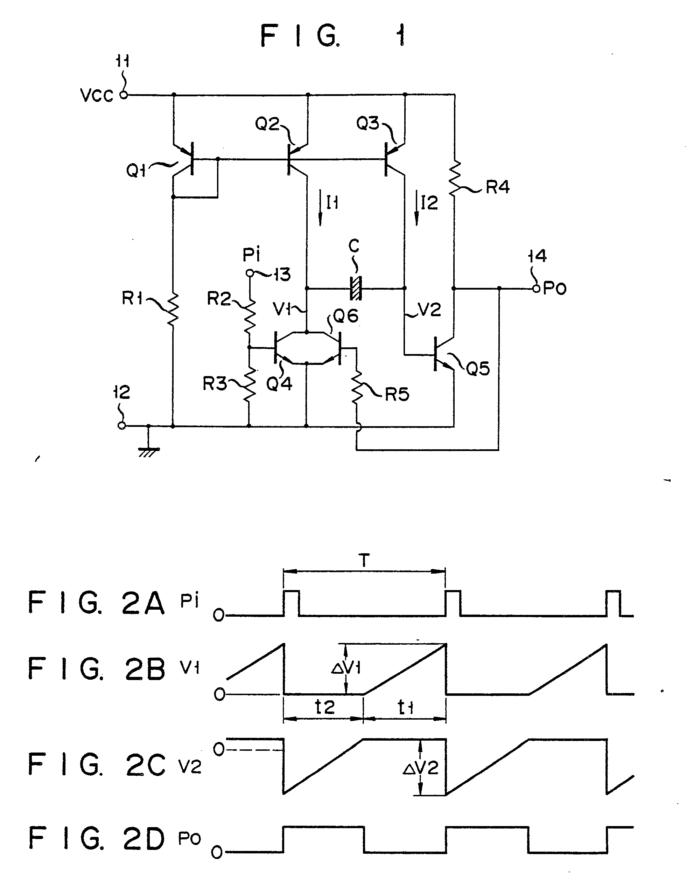

As shown in Fig. 1, a pulse regeneration circuit according to the present invention comprises a first power source terminal 11 and a second power source terminal 12. Power source voltage $V_{cc}$ is applied to the first power source terminal 11, and a predetermined reference voltage (i.e. ground potential) is applied to the second power source terminal 12. The circuit further comprises an input terminal 13 for receiving an input pulse Pi (Fig. 2A) and an output terminal 14 for supplying an output pulse (Fig. 2D).

Between the first power source terminal 11 and the second power source terminal 12 a series circuit is connected which consists of a PNP transistor Q1 and a resistor R1. The base and collector of the transistor Q1 are connected to each other. The emitter of the transistor Q1 is connected to the first power source terminal 11, and the base and the collector of the transistor Q1 are connected to the second power source terminal 12 through the resistor R1. Two PNP transistors Q2 and Q3 are provided which are current mirror circuits to the transistor Q1. That is, the bases of these transistors Q2 and Q3 are connected to the base of the transistor Q1, and the emitters of these transistors Q2 and Q3 are connected to the first power source terminal 11.

Between the input terminal 13 and the second power source terminal 12 a series circuit of resistors R2 and R3 is connected for applying a bias voltage. The junction of the resistors R2 and R3 is connected to the base of an NPN transistor Q4. The emitter of the transistor Q4 is connected to the ground potential, and the collector of the transistor Q4 is connected to the collector of the transistor Q2 and to the base of an NPN transistor Q5 via a capacitor C. The emitter of the transistor Q5 is connected to the reference voltage (i.e. ground potential). The collector of the transistor Q5 is connected to the output terminal 14 and also to the first power source terminal 11 through a load resistor R4. The collector of the transistor Q5 is also connected to the base of an NPN transistor Q6 through the load resistor R5. The load resistor R4 may be replaced by an impedance circuit. The collector of the transistor Q6 is connected to the collector of the transistor Q2, and the emitter of the transistor Q6 is connected to the second power source terminal 12.

The function of the pulse regeneration circuit described above will now be described with reference to Figs. 2A through 2D.

A pulse signal Pi consisting of pulses generated at intervals T (Fig. 2A) is supplied to the input terminal 13. While the potential of the signal Pi remains at a high level ("1" level), that is, for the duration of a positive input pulse, the transistor Q4 is on and its collector potential $V_1$ falls to ground potential (i.e., zero potential) as shown in Fig. 2B. When the transistor Q4 is turned on, the electric charge in the capacitor C is instantaneously discharged via the transistor Q4. The base potential $V_2$ of the transistor Q5 then abruptly falls as shown in Fig. 2C. The transistor Q5 is thus turned off. A voltage is applied from the first power source terminal 11 through the resistors R4 and R5 to the base of the transistor Q6. While the transistor Q5 is off and the transistor Q6 is on, the output pulse signal Po has a potential which is determined by the voltage division ratio with which the resistors R4 and R5 divide the power source voltage $V_{CC}$, said potential being a high level ("1" level). When the transistors Q5 and Q6 are turned off and on respectively, current $I_2$ starts flowing from the transistor Q3 to the transistor Q6 through the capacitor C. The capacitor C therefore accumulates an electric charge, and the base potential $V_2$ of the transistor Q5 rises. When the base potential $V_2$ reaches the base-emitter threshold voltage $V_{BET}$ of the transistor Q5, the transistor Q5 is turned on. The potential of the collector of transistor Q5, i.e. the potential of the output terninal 14, falls to ground potential. Consequently, the transistor Q6 is turned off. At this time the potential of the output pulse signal Po is at a low level ("0" level).

If the capacitor C is electrically charged for only a period $t_2$, the potential difference $\Delta V_2$ between the ends of the capacitor C is given by: $I_2 \cdot t_2/C$. The charging period $t_1$ is longer than the duration of the positive pulse of the input pulse signal Pi. Hence, within the charging period $t_2$ the potential of the input terminal 13 falls to ground potential and the transistor Q4 is turned off.

When both transistors Q4 and Q5 are turned off, the capacitor C starts accumulating current $I_1$ and is thus electrically charged opposite to the polarity with which it is charged when it accumulates current $I_2$. As the capacitor C is electrically charged in this manner, the collector potentials of the transistors Q4 and Q6 rise. In this condition the next positive pulse of the input pulse signal Pi is applied to the input terminal 13, the transistor Q4 is turned on, and the electric charge is discharged from the capacitor C through the transistor Q4. As a result, the base potential of the transistor Q5 instantaneously falls. Thereafter, the elements of the circuit operate in the same manner as the first positive pulse is supplied to the input terminal 13. If the capacitor C is electrically charged for only a period $t_1$, the potential difference $\Delta V_1$ between the ends of the capacitor C is given as: $I_1 \cdot t_1/C$.

In this embodiment, $\Delta V_1 \approx \Delta V_2$ and the capacitor C has no impedance in terms of AC current. Therefore, $t_2 = t_1$ and the duty of the output pulse signal Po is 50% if $I_1 \approx I_2$. If $I_1 \neq I_2$, or more specifically, $I_1 = 1$ and $I_2 = 1 + \Delta I (\Delta I > 0)$, $t_1$ and $t_2$ will be given:

$$t_1 = \frac{I + \Delta I}{2I + \Delta I} T$$

$$t_2 = \frac{I}{2I + \Delta I} T.$$

Hence, the duty cycle of the output pulse signal Po can be other than 50% if $I_1$ is not equal to $I_2$. In other words, the duty cycle of the output pulse signal Po can be of any desired value only if currents $I_1$ and $I_2$ are different and the ratio of current $I_1$ to current $I_2$ has a proper value.

In order to make currents $I_1$ and $I_2$ different from each other, it is sufficient to use transistors of different sizes, thus giving them different output current characteristics.

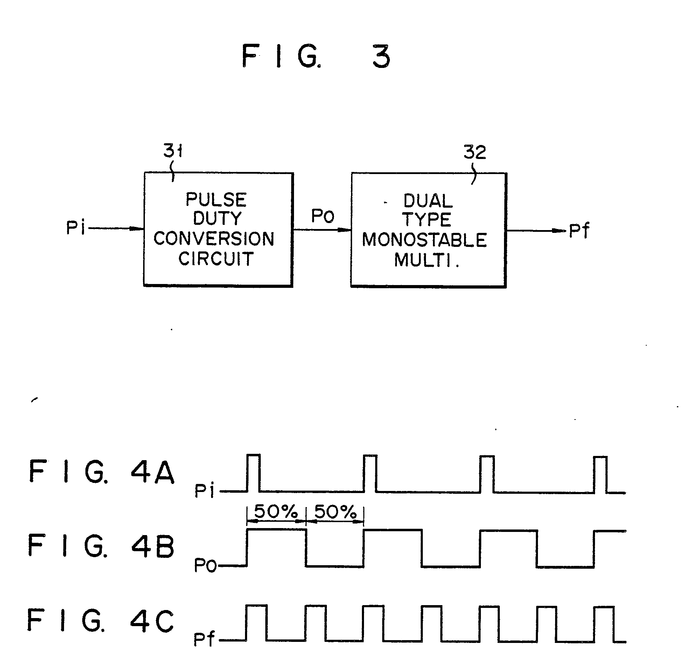

Fig. 3 is a block diagram of a doubler circuit which is provided with the pulse regeneration circuit shown in Fig. 1. Figs. 4A through 4C are timing charts of the signals supplied to various elements of the circuit shown in Fig. 3. The pulse regeneration circuit is a pulse duty conversion circuit 31 designed to convert an input pulse signal into a pulse signal whose duty is 50%. The doubler circuit further comprises a monostable multivibrator 32 of dual trigger type. The multivibrator 32 is designed to receive an output pulse signal Po from the pulse duty conversion circuit 31 and generate two pulses as each pulse of the signal Po rises and falls.

When an input pulse signal Pi, such as is shown in Fig. 4A, is supplied to the pulse duty conversion circuit 31, the circuit 31 generates an output pulse signal Po which is shown in Fig. 4B and whose duty is 50%. The pulse signal Po is supplied to the multivibrator 32. The multivibrator 32 generates two pulses in synchronism with the leading edge and trailing edge of each pulse of the signal Po. Therefore, it generates such a pulse signal Pf as shown in Fig. 4C. As evident from Figs. 4A, 4B and 4C, the pulse signal Pf has a frequency twice that of the input pulse signal Pi (Fig. 4A).

The present invention is not limited to the embodiment described above. As will be well understood from the above, other embodiments are possible within the scope of the invention. For example, the current source circuit consisting of the transistors Q1, Q2 and Q3 and the resistor R1 may be replaced by any other circuit that can determine any desired ratio of the current $I_1$ to the current $I_2$. Further, the reference potential may be other than the ground potential, so far as it is lower than the power source potential $V_{CC}$. Still further, the NPN transistors used in the embodiment may be replaced by PNP transistors and the PNP transistors used in the embodiment may be replaced by NPN transistors. If this is the case, the power source potential $V_{CC}$ and the reference potential will, of course, be interchanged.

As described above, the pulse regeneration circuit according to the invention comprises only a few transistors Q4, Q5 and Q6, only one capacitor C and only two resistors R4 and R5, besides a current source circuit consisting of transistors Q1, Q2 and Q3 and a resistor R1. Its structure is simple. Yet it can convert an input pulse signal into a pulse signal of any desired pulse duty merely by changing the ratio of the current $I_1$ to the current $I_2$. If the pulse duty conversion circuit is combined with a monostable multivibrator of dual trigger type, its pulse duty is set to 50% and its output pulse signal is supplied to the multivibrator, a doubler circuit with a simple structure will be provided.

## Claims

1. A pulse regeneration circuit comprising:
a first current source means (Q2) for supplying a first electric current;
a second current source means (Q3) for supplying a second electric current;
a first transistor (Q4), the collector thereof connected to said first current source means (Q2), the emitter thereof connected to a reference potential and the base thereof connected to receive an input pulse signal;
a second transistor (Q6), the collector thereof connected to said first current source (Q2) and the emitter thereof connected to the reference potential;
a third transistor (Q5), the base thereof connected to said second current source (Q3), the emitter thereof connected to the reference potential and the collector thereof providing an output signal and being connected to a power source potential through a load means (R4);
a capacitor means (C) connected between the base of said third transistor (Q5) and the collector of said first and second transistor (Q4, Q6); and
a feed back loop leading from the collector of said third transistor (Q5) to the base of said second transistor (Q6) through an impedance means (R5);
characterised in that said first and second current source means (Q2, Q3) are first and second constant current source means (Q2, Q3) forming a current mirror circuit, whereby the pulse duty of said output signal is stable and substantially independent of the pulse duty of the input pulse signal.

2. A pulse regeneration circuit according to claim 1, characterised in that said first constant current source means (Q2) and said second constant current source means (Q3) have substantially the same output current characteristics.

3. A pulse regeneration circuit according to claim 1, characterised in that said first constant current source means (Q2) and said second constant current source means (Q3) have different output current characteristics.

4. A pulse regeneration circuit according to claim 1, characterised in that said first constant current source means (Q2) is a fourth transistor, and said second constant current source means (Q3) is a fifth transistor.

5. A pulse regeneration circuit according to claim 4, characterised in that said fourth and fifth transistors are substantially the same size.

6. A pulse regeneration circuit according to claim 4, characterised in that said fourth and fifth transistors are different in size.

7. A pulse regeneration circuit according to claim 1, characterised in that said load means (R4) is a resistor.

8. A pulse regeneration circuit according to claim 1, characterised in that said impedance means (R5) is a resistor.

9. A pulse regeneration circuit comprising:
a first current source means (Q2) for supplying a first electric current;
a second current source means (Q3) for supplying a second electric current;
a capacitor means (C) connected between said first and second current source means (Q2, Q3);
a first switching means (Q4) connected between said first current source means (Q2) and a reference potential and controlled by an input pulse signal;
a second switching means (Q6) connected in parallel to said first switching means (Q4);
a third switching means (Q5) connected at one end to a power source potential through a load means (R4) and at the other end to said reference potential and controlled by the potential of said capacitor means (C); and
the potential at said one end of said third switching means (Q5) forming an output and being applied to said second switching means (Q6) through an impedance means (R5) to control said second switching means (Q6);
characterised in that said first and second current source means (Q2, Q3) are first and second constant current source means (Q2, Q3) forming a current mirror circuit, whereby the pulse duty of said output is stable and substantially independent of the pulse duty of said input pulse signal.

10. A pulse regeneration circuit according to claim 9, characterised in that first switching means (Q4) is a first transistor (Q4), the collector thereof connected to said first constant current source means (Q2), the emitter thereof connected to the reference potential and the base thereof connected to receive the input pulse signal, said second switching means (Q6) is a second transistor (Q6), the collector thereof connected to said first constant current source means (Q2) and the emitter thereof connected to the reference potential, and said third switching means (Q5) is a third transistor (Q5), the base thereof connected to said second constant current source means (Q3), the emitter thereof connected to the reference potential and the collector thereof connected to the base of said second transistor (Q6) through said impedance means (R5) and to the power source potential through the load means (R4).

11. A pulse regeneration circuit according to claim 9, characterised in that said first constant current source means (Q2) and said second constant current source means (Q3) have substantially the same output current characteristics.

12. A pulse regeneration circuit according to claim 9, characterised in that said first constant current source means (Q2) and said second constant current source means (Q3) have different output current characteristics.

13. A pulse regeneration circuit according to claim 9, characterised in that said first constant current source means (Q2) is a fourth transistor, and said second constant current source means (Q3) is a fifth transistor.

14. A pulse regeneration circuit according to claim 13, characterised in that said fourth and fifth transistors are substantially the same size.

15. A pulse regeneration circuit according to claim 13, characterised in that said fourth and fifth transistors are different in size.

16. A pulse regeneration circuit according to claim 9, characterised in that said load means (R4) is a resistor.

17. A pulse regeneration circuit according to claim 9, characterised in that said impedance means (R5) is a resistor.

**Patentansprüche**

1. Impulsregenerationsschaltung umfassend:
eine erste Stromquelleneinrichtung (Q2) zur Lieferung eines ersten elektrische Stromes,
eine zweite Stromquelleneinrichtung (Q3) zur Lieferung eines zweiten elektrischen Stromes,
einen ersten Transistor (Q4), dessen Kollektor mit der ersten Stromquelleneinrichtung (Q2) verbunden ist, dessen Emitter an einem Referenzpotential angeschlossen ist und dessen Basis angeschlossen ist, um ein Eingansimpulssignal zu empfangen,
einen zweiten Transistor (Q6), dessen Kollektor mit der ersten Stromquelle (Q2) verbunden ist und dessen Emitter an das Referenzpotential angeschlossen ist,
einen dritten Transistor (Q5), dessen Basis mit der zweiten Stromquelle (Q3) verbunden ist, dessen Emitter an das Referenzpotential angeschlossen ist und dessen Kollektor ein Ausgangssignal liefert und über eine Lasteinrichtung (R4) mit einem Leistungsquellenpotential verbunden ist,
eine Kondensatoreinrichtung (C), die zwischen der Basis des dritten Transistors (Q5) und dem Kollektor des ersten und zweiten Transistors (Q4), Q6) angeschlossen ist, und
eine Rückkopplungsschleife, die vom Kollektor des dritten Transistors (Q5) zur Basis des zweiten Transistors (Q6) über eine Impedanzeinrichtung (R5) führt,
dadurch gekennzeichnet, daß die erste und zweite Stromquelleneinrichtung (Q2, Q3) eine erste und zweite Konstant - Stromquelleneinrichtung (Q2, Q3) ist, die eine Stromspiegelschaltung bildet, wodurch das Impuls-Tast-Verhältnis des Ausganssignals stabil und im wesentlichen unabhängig vom Impuls-Tast-Verhältnis des Eingangsimpulssignals ist.

2. Impulsregenerationsschaltung nach Anspruch 1, dadurch gekennzeichnet, daß die erste Konstant - Stromquelleneinrichtung (Q2) und die zweite Konstant - Stromquelleneinrichtung (Q3) im wesentlichen die gleichen Ausgangs-Strom - charakteristiken aufweisen.

3. Impulsregenerationsschaltung nach Anspruch 1, dadurch gekennzeichnet, daß die erste Konstant-Stromquelleneinrichtung (Q2) und die zweite Konstant-Stromquelleneinrichtung (Q3) unterschiedliche Ausgangsstromcharakteristken aufweisen.

4. Impulsregenerationsschaltung nach Anspruch 1, dadurch gekennzeichnet, daß die erste Konstantstromquelleneinrichtung (Q2) ein vierter Transistor ist und daß die zweite Konstantstromquelleneinrichtung (Q3) ein fünfter Transistor ist.

5. Impulsregenerationsschaltung nach Anspruch 4, dadurch gekennzeichnet, daß der vierte und fünfte Transistor im wesentlichen die gleiche Größe aufweisen.

6. Impulsregenerationsschaltung nach Anspruch 4, dadurch gekennzeichnet, daß der vierte und fünfte Transistor in ihrer Größe unterschiedlich sind.

7. Impulsregenerationsschaltung nach Anspruch 1, dadurch gekennzeichnet, daß die Lasteinrichtung (R4) ein Widerstand ist.

8. Impulsregenerationsschaltung nach Anspruch 1, dadurch gekennzeichnet, daß die Impedanzeinrichtung (R5) ein Widerstand ist.

9. Impulsregenerationsschaltung umfassend:
eine erste Stromquelleneinrichtung (Q2) zur Lieferung eines ersten elektrischen Stromes,
eine zweite Stromquelleneinrichtung (Q3) zur Lieferung eines zweiten elektrischen Stromes,
eine Kondensatoreinrichtung (C), die zwischen der ersten und zweiten Stromquelleneinrichtung (Q2, Q3) angeschlossen ist,
eine erste Schalteinrichtung (Q4), die zwischen der ersten Stromquelleneinrichtung (Q2) und einem Referenzpotential angeschlossen ist und durch ein Eingangsimpulssignal gesteuert wird,
eine zweite Schalteinrichtung (Q6), die parallel zur ersten Schalteinrichtung (Q4) angeschlossen ist,
eine dritte Schalteinrichtung (Q5), die an einem Ende mit einem Leistungsquellenpotential über eine Lasteinrichtung (R4) und am anderen Ende mit dem Referenzpotential verbunden ist und durch das Potential der Kondensatoreinrichtungen (C) gesteuert wird, wobei das Potential an dem einen Ende der dritten Schalteinrichtung (Q5) ein Ausgangssignal bildet und an die zweite Schalteinrichtung (Q6) über eine Impedanzeinrichtung (R5) angelegt ist, um die zweite Schalteinrichtung (Q6) zu steuern, dadurch gekenzeichnet, daß die erste und zweite Stromquelleneinrichtung (Q2, Q3) eine erste und zweite Konstantstromquelleneinrichtung (Q2, Q3) ist und eine Stromspiegelschaltung bildet, wodurch das Impuls-Tast-Verhältnis des Ausganssignals stabil und im wesentlichen unabhängig vom Impuls-Tast-Verhältnis des Eingangsimpulssignals ist.

10. Impulsregenerationsschaltung nach Anspruch 9, dadurch gekennzeichnet, daß erste Schalteinrichtung (Q4) ein erster Transistor (Q4) ist, dessen Kollektor mit der ersten Konstantstromquelleneinrichtung (Q2) verbunden ist, dessen Emitter an das Referenzpotential angeschlossen ist und dessen Basis angeschlossen ist, um das Eingangsimpulssignal zu empfangen, daß die zweite Schalteinrichtung (Q6) ein zweiter Transistor (Q6) ist, dessen Kollektor an die erste Konstantstromquelleneinrichtung (Q2) angeschlossen ist und dessen Emitter mit dem Referenzpotential verbunden ist und daß die dritte Schalteinrichtung (Q5) ein dritter Transistor (Q5) ist, dessen Basis mit der zweiten Konstantstromquelleneinrichtung (Q3) verbunden ist, dessen Emitter an das Referenzpotential angeschlossen ist und dessen Kollektor über die Impedanzeinrichtung (R5) mit der Basis des zweiten Transistors (Q6) verbunden ist, sowie über die Lasteinrichtung (R4) mit dem Leistungsquellenpotential.

11. Impulsregenerationsschaltung nach Anspruch 9, dadurch gekennzeichnet, daß die erste Konstantstromquelleneinrichtung (Q2) und die zweite Konstantstromquelleneinrichtung (Q3) im wesentlichen die gleiche Ausgangsstromcharakteristiken aufweisen.

12. Impulsregenerationsschaltung nach Anspruch 9, dadurch gekennzeichnet, daß die erste Konstantstromquelleneinrichtung (Q2) und die zweite Konstantstromquelleneinrichtung (Q3) unterschiedliche Ausgangsstromcharakteristiken besitzen.

13. Impulsregenerationsschaltung nach Anspruch 9, dadurch gekennzeichnet, daß die erste Konstantstromquelleneinrichtung (Q2) ein vierter Transistor ist und daß die zweite Konstantstromquelleneinrichtung (Q3) ein fünfter Transistor ist.

14. Impulsregenerationsschaltung nach Anspruch 13, dadurch gekennzeichnet, daß der vierte und fünfte Transistor im wesentlichen die gleiche Größe aufweisen.

15. Impulsregenerationsschaltung nach Anspruch 13, dadurch gekennzeichnet, daß der vierte und fünfte Transistor von unterschiedlicher Größe sind.

16. Impulsregenerationsschaltung nach Anspruch 9, dadurch gekennzeichnet, daß die Lasteinrichtung (R4) ein Widerstand ist.

17. Impulsregenerationsschaltung nach Anspruch 9, dadurch gekennzeichnet, daß die Impedanzeinrichtung (R5) ein Widerstand ist.

**Revendications**

1. Circuit de régénération d'impulsions comprenant:
une première source de courant (Q2) servant à délivrer un premier courant électrique;
une deuxième source de courant (Q3) servant à délivrer un deuxième courant électrique;
un premier transistor (Q4), dont le collecteur est connecté à la première source de courant (Q2), dont l'émetteur est connecté à un potentiel de référence, et dont la base est connectée de façon à recevoir un signal d'impulsion d'entrée;
un deuxième transistor (Q6), dont le collecteur est connecté à la première source de courant (Q2) et dont l'émetteur est connecté au potentiel de référence;
un troisième transistor (Q5), dont la base est connectée à la deuxième source de courant (Q3), dont l'émetteur est connecté au potentiel de référence et dont le collecteur produit un signal de sortie et est connecté à un potentiel de source d'alimentation par l'intermédiaire d'une charge (R4);
un condensateur (C) connecté entre la base du troisième transistor (Q5) et le collecteur des premier et deuxième transistors (Q4, Q6); et
une boucle de réaction conduisant du collecteur dudit troisième transistor (Q5) à la base dudit deuxième transistor (Q6) par l'intermédiaire d'une impédance (R5); caractérisé en ce que lesdites première et deuxième sources de courant (Q2, Q3) sont constituées par une première et une deuxième source de courant constant (Q2, Q3) formant un circuit miroir de courant, si bien que le coefficient d'utilisation d'impulsions dudit signal de sortie est stable et est sensiblement indépendant du coefficient d'utilisation d'impulsions du signal d'impulsion d'entrée.

2. Circuit de régénération d'impulsions selon la revendication 1, caractérisé en ce que ladite première source de courant constant (Q2) et ladite deuxième source de courant constant (Q3) ont sensiblement la même caractéristique de courant de sortie.

3. Circuit de régénération d'impulsions selon la revendication 1, caractérisé en ce que ladite première source de courant constant (Q2) et ladite deuxième source de courant constant (Q3) ont des caractéristiques de courant de sortie différentes.

4. Circuit de régénéation d'impulsions selon la revendication 1, caractérisé en ce que ladite première source de courant constant (Q2) est un quatrième transistor, et ladite deuxième source de courant constant (Q3) est un cinquième transistor.

5. Circuit de régénération d'impulsions selon la revendication 4, caractérisé en ce que lesdits quatrième et cinquième transistors ont sensiblement la même dimension.

6. Circuit de régénération d'impulsions selon la revendication 4, caractérisé en ce que lesdits quatrième et cinquième transistors ont des dimensions différentes.

7. Circuit de régénération d'impulsions selon la revendication 1, caractérisé en ce que ladite charge (R4) est une résistance.

8. Circuit de régénération d'impulsions selon la revendication 1, caractérisé en ce que ladite impédance (R5) est une résistance.

9. Circuit de régénération d'impulsions comprenant:
une première source de courant (Q2) servant à délivrer un premier courant électrique;

une deuxième source de courant (Q3) servant à délivrer un deuxième courant électrique;

un condensateur (C) connecté entre lesdites première et deuxième sources de courant (Q2, Q3);

un premier moyen de commutation (Q4) connecté entre ladite première source de courant (Q2) et un potentiel de référence et commandé par un signal d'impulsion d'entrée;

un deuxième moyen de commutation (Q6) connecté en parallèle avec ledit premier moyen de commutation (Q4);

un troisième moyen de commutation (Q5) connecté par une extrémité à un potentiel de source électrique par l'intermédiaire d'une charge (R4) et, par l'autre extrémité, audit potentiel de référence et commandé par le potentiel dudit condensateur (C) et

le potentiel présent sur ladite première extrémité dudit troisième moyen de commutation (Q5) formant un signal de sortie et étant appliqué audit deuxième moyen de commutation (Q6) par l'intermédiaire d'une impédance (R5) afin de commander ledit deuxième moyen de commutation (Q6); caractérisé en ce que lesdites première et deuxième sources de courant (Q2, Q3) sont une première et une deuxième source de courant constant (Q2, Q3) formant un circuit miroir de courant, de sorte que le coefficient d'utilisation d'impulsions dudit signal de sortie est stable et est sensiblement indépendant du coefficient d'utilisation d'impulsions dudit signal d'impulsion d'entrée.

10. Circuit de régénération d'impulsions selon la revendication 9, caractérisé en ce que ledit premier moyen de commutation (Q4) est un premier transistor (Q4), dont le collecteur est connecté à ladite première source de courant constant (Q2), dont l'émetteur est connecté au potentiel de référence et dont la base est connectée de façon à recevoir le signal d'impulsion d'entrée, ledit deuxième moyen de commutation (Q6) est un deuxième transistor (Q6), dont le collecteur est connecté à ladite première source de courant constant (Q2) et dont l'émetteur est connecté au potentiel de référence, et ledit troisième moyen de commutation (Q5) est un troisième transistor (Q5), dont la base est connectée à ladite deuxième source de courant constant (Q3), dont l'émetteur est connecté audit potentiel de référence et dont le collecteur est connecté à la base dudit deuxième transistor (Q6) par l'intermédiaire de ladite impédance (R5) et au potentiel de source électrique par l'intermédiaire de la charge (R4).

11. Circuit de régénération d'impulsions selon la revendication 9, caractérisé en ce que ladite première source de courant constant (Q2) et ladite deuxième source de courant constant (Q3) ont la même caractéristique de courant de sortie.

12. Circuit de régénération d'impulsions selon la revendication 9, caractérisé en ce que ladite première source de courant constant (Q2) et ladite deuxième source de courant constant (Q3) ont des caractéristiques de courant de sortie différentes.

13. Circuit de régénération d'impulsions selon la revendication 9, caractérisé en ce que ladite première source de courant constant (Q2) est un quatrième transistor, et ladite deuxième source de courant constant (Q3) est un cinquième transistor.

14. Circuit de régénération d'impulsions selon la revendication 13, caractérisé en ce que lesdits quatrième et cinquième transistors ont sensiblement la même dimension.

15. Circuit de régénération d'impulsions selon la revendication 13, caractérisé en ce que lesdits quatrième et cinquième transistors ont des dimensions différentes.

16. Circuit de régénération d'impulsions selon la revendication 9, caractérisé en ce que ladite charge (R4) est une résistance.

17. Circuit de régénération d'impulsions selon la revendication 9, caractérisé en ce que ladite impédance (R5) est une résistance.

# F I G. 1

F I G. 2A Pi

F I G. 2B V1

F I G. 2C V2

F I G. 2D Po

# F I G. 3

```
Pi ──▶ ┌──────────────┐        ┌──────────────┐
       │    PULSE      │   Po   │    DUAL      │
       │    DUTY       │ ─────▶ │    TYPE      │ ──▶ Pf
       │  CONVERSION   │        │  MONOSTABLE  │
       │   CIRCUIT     │        │    MULTI.     │
       └──────────────┘        └──────────────┘
            31                      32
```

F I G. 4A  Pi

F I G. 4B  Po

F I G. 4C  Pf